# EUROPÄISCHE PATENTSCHRIFT

(11) **EP 2 456 997 B1**
(45) Veröffentlichungstag und Bekanntmachung des Hinweises auf die Patenterteilung: **26.03.2014**
(21) Anmeldenummer: 10736616.3
(22) Anmeldetag: 14.07.2010
(51) Int. Cl.: F16F 7/108

(54) **LASTPLATTE UND VERFAHREN ZUR LAGERUNG EINES MEDIZINTECHNISCHEN GROSSGERÄTS UND HERSTELLUNGSVERFAHREN FÜR EINE LASTPLATTE**
LOAD-BEARING PLATE AND METHOD FOR SUPPORTING A BULKY DEVICE OF MEDICAL ENGINEERING AND METHOD FOR PRODUCING A LOAD-BEARING PLATE
PLAQUE PORTE-CHARGE, PROCÉDÉ DE MONTAGE D'UN APPAREIL MÉDICO-TECHNIQUE DE GRANDE TAILLE ET PROCÉDÉ DE FABRICATION D'UNE PLAQUE PORTE-CHARGE

(30) Priorität: 23.07.2009 DE 102009034563
(43) Veröffentlichungstag der Anmeldung: 30.05.2012
(73) Patentinhaber: Anderssohn, Uwe, 83627 Warngau (DE); Kreissig, Hartmut, 58640 Iserlohn (DE)
(72) Erfinder: Anderssohn, Uwe, 83627 Warngau (DE); Kreissig, Hartmut, 58640 Iserlohn (DE)
(74) Vertreter: Beckord & Niedlich
(86) Internationale Anmeldenummer: PCT/EP2010/004290
(87) Internationale Veröffentlichungsnummer: WO 2011/009553

(56) Entgegenhaltungen:
- DE-A1- 3 510 809
- JP-A- 58 137 634
- US-A- 3 421 326

## Beschreibung

Die vorliegende Erfindung betrifft eine Lastplatte und ein Verfahren zur Lagerung eines medizintechnischen Großgeräts, insbesondere eines Magnetresonanzaufnahmegeräts. Außerdem betrifft sie ein Herstellungsverfahren für eine solche Lastplatte.

Bei der Lagerung medizintechnischer Großgeräte, insbesondere von Magnetresonanzaufnahmegeräten, muss zahlreichen Zusatzanforderungen Rechnung getragen werden, die bei der Lagerung herkömmlicher Großgeräte wie beispielsweise von Produktionsmaschinen im industriellen oder gewerblichen Bereich, keine oder nur eine untergeordnete Rolle spielen.

Dies ist einerseits das große Gewicht, das auf den Boden eines Aufstellraums des Großgeräts so verteilt werden muss, dass es möglichst nicht rein punktuell wirkt, denn medizinische Großgeräte werden üblicherweise nicht in eigens entsprechend stabil gebauten Maschinenhallen aufgestellt, sondern in Praxisräumen, die ähnlich wie Büroräume nur eine eingeschränktere Gebäudestabilität aufweisen. Andererseits spielt die besondere Art der Schwingungen, die beim Betrieb von medizintechnischen Geräten entstehen, eine wichtige Rolle.

Die derzeitige Entwicklung in der Magnetresonanztomographie beispielsweise führt zu immer höheren Grund-Magnetfeldstärken und immer schnelleren Gradientensystemen. Damit verbunden ist eine höhere mechanische Belastung der Magneten und letztlich eine erhöhte Geräuschemission. Diese Emissionen müssen aus Gründen des Lärm- und des Arbeitsschutzes sowie im Interesse der zu untersuchenden Patienten minimiert werden, weshalb in Deutschland beispielsweise bei Magnetresonanztomographen ein Pegel von 35 dB in sogenannten Fremdbereichen des Tomographen nicht überschritten werden darf. Diese wird durch zweierlei Arten von Maßnahmen erreicht: Der Luftschall wird durch geeignet verstärkte Isolierungsmaßnahmen des Geräts unter den zulässigen Grenzwerten gehalten, während der Körperschall, der sich vom Gerät auf den Boden des Aufstellraums übertragen würde, durch komplexe Entkopplungsmechanismen abgedämpft wird. Hierbei kommen Lastplatten zum Einsatz, die eine hohe Eigensteifigkeit und ein hohes Eigengewicht von mindestens 1,8 bis 2,0 Tonnen aufweisen.

Die zur Verwendung kommenden Lastplatten müssen im Gegensatz zu Lastplatten für die meisten üblichen gewerblichen Großgeräte noch weitere Kriterien erfüllen, die heute mit erheblichem zeitlichen und/oder Kostenaufwand bei der Bereitstellung verbunden sind:

Zum Einen stellt die Bauhöhe von Lastplatten einen wichtigen Faktor da, da medizintechnische Großgeräte darauf ausgelegt sind, in einer bestimmten Höhe aufgestellt zu werden, in der ein Patient bequem gelagert werden kann. Zudem sollen die Großgeräte auch bei Räumen mit heute üblichen Raumhöhenmaßen, beispielsweise in Arztpraxen, aufgestellt werden sollen. Da das Großgerät selbst schon, je nach Ausführung technische Raumhöhen zwischen ca. 235cm - 270cm benötigt, ist der Raum für eine Lastplatte sehr knapp bemessen. In Arztpraxen sind nämlich häufig Höhen zwischen Rohboden und Rohdecke von unter 300cm vorzufinden, bei denen durch statische Verstärkungen für das Großgerät noch bis 25cm Raumhöhe verloren gehen.

Zum Anderen ist mit dem Betrieb von medizintechnischen Großgeräten, insbesondere von Magnetresonanzaufnahmegeräten, eine erhebliche Magnetfeldemission verbunden, wobei gleichzeitig unbedingt vermieden werden muss, dass magnetische Störeinflüsse im Umfeld des Magneten eine Rolle spielen. Somit können beispielsweise die üblicherweise bei gewerblichen Maschinen verwendeten Eisenplatten als Lastplatten nicht zur Anwendung kommen, da durch ihre magnetischen Störeinflüsse das homogene Grundmagnetfeld des Magnetresonanzgeräts so verzerrt würde, dass eine qualitativ hochwertige Bildgebung unmöglich würde.

Die DE 35 10 809 A1 schlägt für die Lagerung von herkömmlichen Maschinen eine Schalldämmeinrichtung vor, die eine doppelt elastische Lagerung von schweren Maschinen, beispielsweise Kompressoren und großen Verbrennungsmotoren, ermöglicht. Hierfür wird neben verschiedenen dämpfenden Federelementen in punktelastischer Lagerung ein Zwischenelement in Form einer Lastplatte verwendet, die mit Bleischrot gefüllt ist. Durch eine solche Bleischrotfüllung wird ein höheres Gesamtgewicht erzielt, jedoch besteht dabei die Gefahr, dass das Bleischrot durch die abzufedernden Schwingungen selbst hin- und her verschoben wird. Dadurch kann es sukzessive zu Gewichtsverlagerungen des Bleischrots kommen, die bei der Schalldämmung jedoch unbedingt vermieden werden sollen. Derzeit werden daher als Lastplatten für medizintechnische Großgeräte entweder Edelstahl-Platten oder gegossene Beton-Lastplatten verwendet.

Da der Transport eines einzelnen Edelstahlblocks mit einer Masse von 1,8 Tonnen innerhalb eines Gebäudes in der Regel nicht möglich ist, werden mehrere großflächige Platten vor Ort zu einem Block verschraubt. Da diese Platten aus Gründen der mechanischen Festigkeit in der Regel etwa 1 cm stark sein müssen, weisen sie noch immer ein hohes Gewicht von erfahrungsgemäß mindestens 160 kg auf. Bei Platten mit einem Gewicht von 160 kg ist zudem nur eine relativ geringe mechanische Steifigkeit gegeben. Insbesondere hat ein Aufbau mit Edelstahlplatten im Vergleich zu Eisenplatten den Nachteil erheblicher Mehrkosten.

Auch die Verwendung einer Lastplatte aus Beton oder Barytbeton bringt erhebliche Nachteile mit sich. Erstens ergibt sich ein wesentlich dickerer Aufbau der Lastplatte von in etwa 12 bis 18 cm aufgrund der niedrigeren Dichte von Beton im Vergleich zu Edelstahl. Zweitens muss vor dem Gießen der Lastplatte vor Ort eine Hochfrequenzabschirmung am Boden des Aufstellraums installiert, d. h. in der Regel gegossen, werden und ggf. müssen weitere Aufbauschichten darauf aufgebracht werden, auf denen dann die Lastplatte aufgebaut wird. Diese Aufbauarbeiten müssen zeitlich gesplittet werden, so dass sich ein zeitlicher Mehraufwand ergibt, der zudem drittens noch deutlich durch die lange Trocknungszeit des Betons erhöht wird.

Vor diesem Hintergrund ist es Aufgabe der Erfindung, eine verbesserte Möglichkeit der Lagerung von medizintechnischen Großgeräten unter Verwendung einer Lastplatte bereitzustellen. Die Verbesserung soll vorzugsweise insbesondere in einer Verbilligung des Herstellungsprozesses und/oder der Verkürzung von Bereitstellungszeiten bestehen, wobei die Stabilität der Lastplatte im Vergleich zum Stand der Technik mindestens gleich bleiben soll.

Diese Aufgabe wird durch eine Lastplatte gemäß Anspruch 1 sowie durch ein Herstellungsverfahren gemäß Anspruch 19 und ein Verfahren gemäß Anspruch 20 gelöst.

Demgemäß weist eine erfindungsgemäße Lastplatte zur Lagerung eines medizintechnischen Großgeräts, insbesondere eines Magnetresonanzaufnahmegeräts, einen flachen Hohlkörper auf, der mit einem Füllmaterial hoher Dichte gefüllt ist, wobei das Füllmaterial in sich mit Hilfe eines verfestigten Vergussmaterials zu einem starren Verbund vergossen ist und sowohl der Hohlkörper als auch das Füllmaterial und das Vergussmaterial aus nichtmagnetischem Material bestehen.

Die Erfindung bedient sich also eines gefüllten flachen Hohlkörpers mit einem Füllmaterial, das mit Hilfe eines Vergussmaterials zu einem starren Verbund verbunden ist. Als flacher Hohlkörper wird eine in ihrer Breite und Tiefe größer als in ihrer Höhe dimensionierte Aufnahmevorrichtung verstanden. Dabei wird als Höhe die Raumrichtung definiert, die sich bei bestimmungsgemäßer Anordnung der Lastplatte vom Boden eines Aufstellraums in Richtung des aufzustellenden Großgeräts erstreckt.

Das Füllmaterial weist eine hohe Dichte auf, wobei hierunter zu verstehen ist, dass seine Dichte auf jeden Fall oberhalb derer von Beton liegt, d.h. oberhalb von 2500 kg/m3, bevorzugt oberhalb 5000 kg/m3, besonders bevorzugt oberhalb 10000 kg/m3. Damit kann erreicht werden, dass die Bauhöhe der Lastplatte im Vergleich zu Beton deutlich reduzierbar ist, bei einer Dichte oberhalb 10000 kg/m3 sogar gegenüber der Bauhöhe von Eisen- oder Edelstahl-Lastplatten.

Die Form, in der das Füllmaterial vorgehalten wird, ist je nach Einsatzort der Lastplatte grundsätzlich variabel. So können beispielsweise dünne Materialplatten verwendet werden, die vorzugsweise eine Dicke von unter 10 mm, besonders bevorzugt unter 5 mm, aufweisen. Im Gegensatz zu den Edelstahlplatten gemäß dem Stand der Technik werden also bevorzugt dünnere Platten genutzt, zudem besonders bevorzugt aus einem dichteren Material. Alternativ kann auch ein Rollenmaterial eingesetzt werden.

Dieses Füllmaterial ist mit Hilfe eines Vergussmaterials zu einem Verbund vergossen, d. h. verbunden. Es handelt sich also um eine Art adhäsiver Verbindung unter den einzelnen Teilelementen des Füllmaterials, die nach dem Verfestigen des Vergussmaterials permanent für einen festen Verbund von Hohlkörper und Füllmaterial sowie innerhalb des Füllmaterials selbst sorgt. Es entsteht damit ein ähnlicher Effekt wie bei einer einstückigen Ausbildung einer Lastplatte aus einem Material, nämlich die Bildung einer kompakten Einheit als Lastplatte, allerdings unter Umgehung aller oben genannter Nachteile bei der Bereitstellung von Lastplatten aus einzelnen Edelstahlplatten oder aus gegossenem Beton. Die einzelnen Bestandteile der erfindungsgemäßen Lastplatte können vor Ort nach Belieben verbracht und dort assembliert werden. Damit entfallen die Erschwernisse gemäß dem Stand der Technik, insbesondere der hohe Transportaufwand aufgrund der großen Massen. Ein sehr wichtiger Vorteil der erfindungsgemäßen Lastplatte ist neben dieser vereinfachten Herstellbarkeit, dass das Füllmaterial im Gegensatz zum Stand der Technik in der DE 35 10 809 A1 nach dem Verguss eine kompakte Platte bildet und die Entkopplung von Körperschall, wie er typischerweise von medizintechnischen Großgeräten emittiert wird, erheblich besser funktioniert als bei mehrteiligen Dämpfungsgegengewichten. Die kompakte Einheit in Form eines stabilen Verbunds ist daher ideal nutzbar im Rahmen eines Masse-Feder-Systems zur Lagerung medizintechnischer Großgeräte.

Selbst wenn man als Vergussmaterial wiederum Beton verwendete, was im Rahmen der Erfindung explizit nicht ausgeschlossen ist, so reduzierten sich die Trocknungszeiten durch das Füllmaterial doch erheblich. Es ist daher im Rahmen der Erfindung besonders bevorzugt, dass das Füllmaterial einen Volumenanteil von mehr als der Hälfte des Inhalts des Hohlkörpers äusfüllt, besonders bevorzugt mehr als 80 %.

Sowohl der Hohlkörper als auch das Füll- und das Vergussmaterial bestehen aus nichtmagnetischem Material. Dies bedeutet, dass es sich um ein nicht magnetisierbares, d. h. nicht bzw. vernachlässigbar ferromagnetisches Material handelt. Der Grenzwert der Magnetisierbarkeit wird hierbei üblicherweise nicht in absoluten Werten des magnetischen Flusses angegeben, sondern definiert sich aus der verwendeten Eisenmasse pro m² Aufstellfläche in Relation zum notwendigen Abstand des Isozentrums eines medizintechnischen Großgeräts, insbesondere eines Magnetresonanzgeräts, von der Lastplatte. Beispielsweise darf bei den Magnetresonanzgeräten der Firma Siemens: "Magnetom Trio" (Grundmagnetfeldstärke 3,0 Tesla), "Magnetom Verio (Grundmagnetfeldstärke 3,0 Tesla), "Magnetom Avanto" (Grundmagnetfeldstärke 1,5 Tesla) und "Magnetom Espree" (Grundmagnetfeldstärke 1,5 Tesla) eine statische Eisenmasse von 100 kg/m² aller baulichen Eisenmassen inklusive der Lastplatte unterhalb der Standfläche des Magneten nicht überschritten werden. Durch eine entsprechende Materialauswahl kann sichergestellt werden, dass durch die Lastplatte keine magnetischen Störfelder entstehen, die beispielsweise eine Magnetresonanzbildgebung fehlerbildend beeinflussen könnten.

Diese Ausführung einer schweren, hochstabilen Lastplatte, die zudem eine geringe Aufbauhöhe haben kann, ist universell für unterschiedliche Typen von medizintechnischen Großgeräten, insbesondere unterschiedliche Magnetresonanzaufnahmegeräte einsetzbar und kann grundsätzlich auch für die Körperschallentkopplung in anderen Anwendungsbereichen eingesetzt werden. Aufgrund ihrer speziellen nichtmagnetischen und hochstabilen Ausführung ist sie jedoch für Magnetresonanzaufnahmegeräte ganz besonders geeignet und vorgesehen.

Ein entsprechendes Herstellungsverfahren für eine Lastplatte zur Lagerung eines medizintechnischen Großgeräts, insbesondere eines Magnetresonanzaufnahmegeräts, weist mindestens folgende Schritte auf:
a) Bereitstellen eines flachen Hohlkörpers aus nichtmagnetischem Material,
b) Füllen des Hohlkörpers mit einem nichtmagnetischen Füllmaterial hoher Dichte,
c) Vergießen des Füllmaterials mit Hilfe eines sich verfestigenden Vergussmaterials zu einem starren Verbund.

Das Füllen des Hohlkörpers und das Vergießen, d. h. Verbinden, des Füllmaterials wird dabei bevorzugt am Einsatzort der Lastplatte durchgeführt, da damit die oben erwähnten Handling-Vorteile des erfindungsgemäßen Herstellungsverfahrens besonders gut zur Geltung kommen. Die Montage kann zeitgleich mit der Erstellung der Hochfrequenz-Abschirmung durchgeführt werden, und die Lastplatte ist bei der Verwendung geeigneter Materialien (siehe unten) innerhalb von 12 bis 24 Stunden belastbar. Neben diesen Vorteilen ergibt sich außerdem eine enorme Kosteneinsparung aufgrund der reduzierten Arbeitszeiten und der deutlich geringeren Materialkosten, etwa im Vergleich zu einer Ausführung der Lastplatte rein aus Edelstahl-Platten. Einzelne Teilschritte, insbesondere Teilschritte bei der Bereitstellung des flachen Hohlkörpers, können jedoch auch vor der Auslieferung an den Einsatzort durchgeführt werden. Hierunter zählen beispielsweise Formgebungsschritte und anderweitige Veredelungsschritte zur Herstellung des flachen Hohlkörpers.

Das erfindungsgemäße Verfahren zur Lagerung eines medizintechnischen Großgeräts, insbesondere eines Magnetresonanzaufnahmegeräts, an einem Einsatzort des Großgeräts, weist mindestens folgende Schritte auf:
a) Bereitstellen eines flachen Hohlkörpers aus nichtmagnetischem Material,
b) Füllen des Hohlkörpers mit einem nichtmagnetischen Füllmaterial hoher Dichte vor Ort,
c) Vergießen des Füllmaterials vor Ort mit Hilfe eines sich verfestigenden Vergussmaterials zu einem starren Verbund, sodass aus dem Hohlkörper mit dem starren Verbund eine Lastplatte entsteht,
d) Aufstellen des medizinischen Großgeräts auf der Lastplatte.

Das Verfahren zur Lagerung umfasst also außer den Schritten des Herstellungsverfahrens noch das Aufstellen des Großgeräts auf der erfindungsgemäß hergestellten Lastplatte.

Die Erfindung umfasst weiterhin eine Lagerungsanordnung mit einer auf einer Oberfläche eines Bodens eines Aufstellraums angeordneten erfindungsgemäßen Lastplatte. Eine solche Lagerungsanordnung kann insbesondere, wie unten aufgeführt, weitere Lagerungselemente zur Lagerung eines Großgeräts umfassen.

Ebenso umfasst die Erfindung die Verwendung einer erfindungsgemäßen Lastplatte, insbesondere einer erfindungsgemäßen Lagerungsanordnung, zur Lagerung eines medizintechnischen Großgeräts, insbesondere eines Magnetresonanzaufnahmegeräts.

Außerdem betrifft die Erfindung eine medizintechnische Anordnung, umfassend ein medizintechnisches Großgerät, insbesondere ein Magnetresonanzaufnahmegerät, und eine erfindungsgemäße Lastplatte, insbesondere eine erfindungsgemäße Lagerungsanordnung.

Weitere besonders vorteilhafte Ausgestaltungen und Weiterbildungen der Erfindung ergeben sich auch aus den abhängigen Ansprüchen sowie der nachfolgenden Beschreibung. Dabei können die Ansprüche einer Kategorie auch entsprechend den Unteransprüchen einer anderen Kategorie weitergebildet sein.

Besonders bevorzugt umfasst die der Hohlkörper eine Wanne. Diese kann im Endzustand der Lastplatte oder auch bereits vor Fertigstellung der Lastplatte nach oben, d.h. in Richtung des Großgeräts, sowohl offen als auch geschlossen ausgeführt sein. Als Wanne wird insbesondere ein Aufnahmebehälter mit mindestens einer Vertiefung verstanden. Bevorzugt handelt es sich bei der Vertiefung um eine einzelne Vertiefung, die sich über die gesamte Breite und die gesamte Tiefe der Wanne erstreckt, mit Ausnahme von seitlichen und hinteren bzw. vorderen Begrenzungswänden. Diese Begrenzungswände sind in ihrer Dicke vorzugsweise höchstens dreimal so groß dimensioniert wie die Höhe der Wanne im Bereich der Vertiefung, besonders bevorzugt sind sie im Wesentlichen gleich dick wie die Höhe der Wanne im Bereich der Vertiefung. Es kann jedoch in speziellen Fällen auch vorgesehen sein, dass die Vertiefung der Wanne und die DickenAbmessungen ihrer seitlichen und hinteren bzw. vorderen Begrenzungswände anders dimensioniert sind, beispielsweise bei Verwendung von runden oder unregelmäßigen Vertiefungsformen. Es kann weiterhin auch vorteilhaft sein, die Wanne mit mehreren Vertiefungen auszubilden, die vorzugsweise in gleichmässigem Muster zueinander angeordnet sind. Eine solche Anordnung und Ausgestaltung der Vertiefungen kann insbesondere Vorteile durch Erhöhung der Gesamt-Stabilität der Lastplatte bieten.

Gemäß eine vorteilhaften Weiterbildung umfasst die Lastplatte einen die Wanne in Öffnungsrichtung mindestens teilweise abdeckenden Deckel. Die Öffnungsrichtung ist dabei als die Höhenrichtung zum aufzustellenden Großgerät definiert. Eine solche Abdeckung kann die Lastplatte nach oben hin abschließen, so dass sie einen in sich geschlossenen Gesamtverbund darstellt, in den beispielsweise keine Partikel von außen eindringen und zum Beispiel das Vergussmaterial aufweichen können. Dabei kann der Deckel mit Hilfe des Vergussmaterials fest mit dem restlichen Verbund der Lastplatte verbunden werden, oder es können andere, hinlänglich bekannte Verbindungsarten wie Nieten, Schrauben, Verkleben o.ä. gewählt werden. Der Deckel kann die Wanne letztlich auch lose abschließen und dient neben dem Verschluss des Inneren der Wanne auch dem ästhetischeren Anblick der Lastplatte, beispielsweise im Einsatz in Arztpraxen, wo eine nach oben hin offene, mit Vergussmasse gefüllte Wanne eher als störend empfunden würde und eine Abdeckung beispielsweise durch einen angepassten Bodenbelag abgeschlossen wird.

Zur weiteren mechanischen Stabilisierung der Lastplatte in Breiten- und/oder Tiefenrichtung kann gemäß einer bevorzugten Ausführungsform im oder am Hohlkörper mindestens ein Stabilisierungsträger angeordnet sein. Solche Quer- und/oder Längs- bzw. diagonale Verstrebungen dienen auch der weiteren Stabilisierung des Füllmaterials. Sie können beispielsweise als Vierkantrohre oder runde Rohre, jedoch auch als U-Streben, L-Streben, T-Streben, H-Streben oder ähnlich geartete Träger ausgebildet sein. Ihre Anordnung kann sowohl innerhalb des Hohlkörpers als auch angrenzend, bevorzugt seitlich angrenzend, besonders bevorzugt umlaufend seitlich angrenzend erfolgen. Dabei ist es besonders vorteilhaft, dass auch der Stabilisierungsträger aus nichtmagnetischem Material ausgebildet ist, um auch hier magnetische Störfelder ausschließen zu können.

Es hat sich außerdem als vorteilhaft erwiesen, wenn der Hohlkörper bzw., so vorhanden, der oder die Stabilisierungsträger zumindest überwiegend aus Edelstahl bestehen, da es sich hierbei um ein besonders einfach bereitzustellendes Standardmaterial handelt, das im Sinne der obigen Definition nichtmagnetisch ist und eine bewährt hohe Festigkeit aufweist, wie der Stand der Technik bereits zeigt.

Was das Füllmaterial angeht, so wird bevorzugt, dass es ein Schüttgut umfasst bzw. dass es sich um ein Schüttgut handelt, beispielsweise ein Granulat bzw. ein fein- oder grobkörnig vorliegendes Material. Besonders vorteilhaft sind hierfür Quarzsand oder Bleischrot, da sie sowohl eine vergleichsweise hohe Dichte aufweisen und nichtmagnetisch im Sinne der obigen Definition sind. Ein solches Schüttgut kann überallhin praktisch ohne besondere Mühen transportiert und dann vor Ort in den Hohlkörper eingefüllt werden.

Insbesondere bei Blei - in Form von Schüttgut oder in anderer Form, wie beispielsweise von der Rolle - lässt sich aufgrund seiner hohen Dichte selbst für eine Lastplatte von mindestens 1,8 Tonnen eine äußerst geringe Aufbauhöhe von je nach konkreter Ausgestaltung gerade einmal 35 mm oder sogar darunter realisieren.

Das Vergussmaterial umfasst bevorzugt ein Gießharz, beispielsweise ein UV-härtendes Harz wie etwa ein beim Vergießen dünnflüssiges Epoxidharz oder ein Mehrkomponenten-Harz, das durch chemische und/oder physikalische Reaktionen mehrere zusammengebrachter Einzelkomponenten aushärtet. Gießharze sind in der Regel ebenfalls nichtmagnetisch und können aufgrund ihrer ausreichend guten Viskositätseigenschaften gut in den Hohlkörper vergossen werden, wo sie auch in kleine Kavitäten eindringen können. Sie können zudem schnell und stabil aushärten und bieten gute Kohäsionseigenschaften bei der Bildung des Verbunds mit Füllmaterial. Es kann somit ein gut kontrollierbarer Vergieß-Prozess sichergestellt werden, der mit einem verhältnismäßig geringen Zeitaufwand verbunden ist.

Es wird weiterhin bevorzugt, dass das Vergussmaterial ein Material umfasst, das vor dem Verfestigen bereits bei Raumtemperatur einen flüssigen oder zähflüssigen Zustand aufweist. Auf diese Weise kann das Vergussmaterial ohne Anwendung von Schmelz- oder anderen Verflüssigungsprozessen unter üblicherweise vorherrschenden Umweltbedingungen in Aufstellräumen für derlei Lastplatten in den Hohlkörper verbracht werden.

Was die Lagerungsanordnung angeht, so ist es vorteilhaft, wenn die Lastplatte in die Oberfläche des Bodens eingelassen ist, wobei sie besonders bevorzugt mit ihrer dem medizintechnischen Großgerät zugewandten Oberseite im Wesentlichen in einer Ebene mit einer Oberfläche des Bodens, d. h. einer Restfläche des Bodens um eine Einbaukavität herum, oder gar darunter angeordnet ist. Auf diese Weise wird sichergestellt, dass der Boden als zusätzliches stabilisierendes Element dient, der die Lastplatte in Richtung ihrer Breiten- und Tiefenausdehnung begrenzt und hält. Gleichzeitig wird auf diese Weise eine noch geringere Verbauhöhe der Lastplatte realisiert, so dass die Raumhöhe des Aufstellraums optimal genutzt werden kann.

Gemäß einer bevorzugten Ausführungsform ist die Lagerungsanordnung dadurch gekennzeichnet, dass sie auf der dem medizintechnischen Großgerät zugewandten Oberseite der Lastplatte lokal, d. h. voneinander separiert, elastische Federelemente aufweist. Die Lagen dieser Federelemente korrespondieren dabei vorzugsweise mit Positionen von Standbeinen des Großgeräts. Damit wird eine punktelastische Lagerung der Standbeine erzielt, die eine Reihe von Vibrationen, beispielsweise im höher gelegenen Wellenlängenbereich, des Großgeräts bereits dämpft. Solche Federelemente können neben herkömmlichen Federn wie Spiralfedern insbesondere auch federnde Schaumstoffmaterialien umfassen. Alternativ ist es möglich, eine flächige Federung auf der Oberseite vorzusehen, die großflächig mit der Lastplatte in Kontakt steht, d.. h. mindestens ¼ der Oberfläche der Oberseite der Lastplatte bedeckt.

Dabei ist es besonders bevorzugt, dass mindestens eines der Federelemente Teilelemente unterschiedlicher Federkraft umfasst. Auf diese Weise kann ein breites Spektrum von Vibrationsfrequenzen absorbiert werden.

Sinnvollerweise ist die Lagerungsanordnung auf der dem medizintechnischen Großgerät abgewandten Unterseite der Lastplatte eine elastische Federung aufweist. Diese ist vorzugsweise im Wesentlichen ganzflächig ausgebildet, d. h. sie kann beispielsweise als einstückige Dämmschicht ausgebildet sein bzw. ihre Ausdehnung in Breite und Tiefe entspricht im Wesentlichen der der Lastplatte. Diese elastische Federung ist in ihrer Federungswirkung vorzugsweise auf evtl. vorhandene elastische Federelementen abgestimmt und dient der Abfederung des Großgeräts bzw. der Lastplatte, im Endeffekt also der ganzen medizintechnischen Anordnung, gegen den Untergrund des Bodens.

Eine besonders bevorzugte Ausführungsform der Lagerungsanordnung besteht schließlich darin, dass sie eine Hochfrequenz-Abschirmungsschicht zur Abschirmung elektromagnetischer Strahlung umfasst. Diese Schicht dient dazu, die vom Großgerät generierten elektromagnetischen Frequenzen so zu filtern, dass im Aufstellraum eine sogenannte Hochfrequenz-Kabine entsteht und benachbarte Räume nicht oder höchstens gering mit den ausgesandten elektromagnetischen Signalen oder Störungen belastet werden. Außerdem wird so das Meßsystem beispielsweise eines Magnetresonanzaufnahmegeräts durch Hochfrequenzen von außen nicht oder höchstens gering beeinflußt. Die Hochfrequenz-Abschirmung beträgt bevorzugt mehr als 90dB im Meßbereich.

Die Erfindung wird im Folgenden noch einmal unter Hinweis auf die beigefügten Figuren anhand eines Ausführungsbeispiels näher erläutert. Gleiche Bauteile sind in den verschiedenen Figuren jeweils mit denselben Bezugsziffern versehen. Es zeigen:
- Figur 1: eine Schnittansicht eines Ausführungsbeispiels einer medizintechnischen Anordnung mit einer erfindungsgemäßen Lastplatte gemäß einer ersten Ausführungsform,
- Figur 2: eine Schnittansicht einer zweiten Ausführungsform einer erfindungsgemäßen Lastplatte,
- Figur 3: eine schematische Blockdarstellung eines Ausführungsbeispiels eines erfindungsgemäßen Herstellungsverfahrens und in der Weiterführung eines erfindungsgemäßen Verfahrens zur Lagerung.

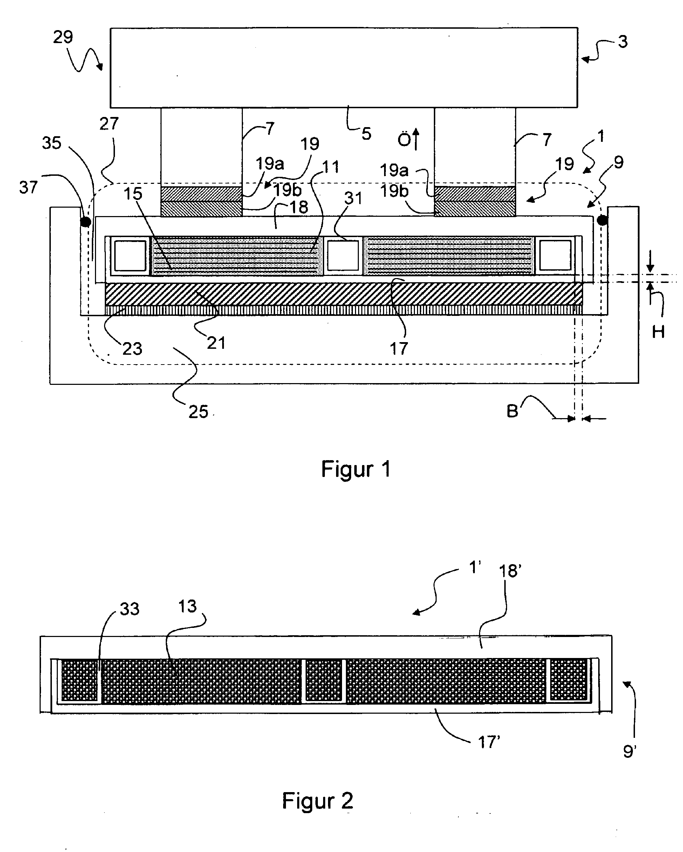

Figur 1 zeigt beispielhaft eine erfindungsgemäße medizintechnische Anordnung 29 auf einem Boden 25 eines Aufstellraums. Die medizintechnische Anordnung 29 umfasst ein medizintechnisches Großgerät 3 in Form eines Magnetresonanzaufnahmegeräts, das hier schematisch durch einen Magneten 5 und zwei Standbeine 7 angedeutet ist, sowie beispielhaft eine erfindungsgemäße Lagerungsanordnung 27.

Die Lagerungsanordnung 27 umfasst eine erfindungsgemäße Lastplatte 1 gemäß einer ersten Ausführungsform sowie an der Oberseite der Lastplatte 1 zwei elastische Federelemente 19 mit Teilelementen 19a, 19b, die unterschiedliche Federkraft aufweisen. Außerdem sind an der Unterseite der Lastplatte 1 eine elastische Federung 21 und eine Hochfrequenz-Abschirmungsschicht 23 angeordnet. Die Federkonstanten der Teilelemente 19a, 19b sind im Verhältnis zum Gewicht der Lastplatte 1 bzw. des Großgeräts 3 bzw. beider in Kombination so gewählt, dass ein breites Frequenzspektrum des Körperschalls des Großgeräts 3 absorbiert wird.

Die Lastplatte 1 umfasst einen Hohlkörper 9, der aus einer Wanne 17 und einem Deckel 18 gebildet ist. Im Inneren des Hohlkörpers 9 befinden sich mehrere Stabilisierungsträger 31 in Form von Vierkantrohren sowie ein Füllmaterial 11, hier in Form von dünnen Materialplatten, beispielsweise aus Blei. Zur Bildung eines Verbunds ist zusätzlich ein Vergussmaterial 15 eingebracht, das ausgehärtet eine Köhäsion und Adhäsion des Füllmaterials 11 in sich und mit den Stabilisierungsträgern 31, der Wanne 17 und dem Deckel 18 bewirkt. Der Deckel 18 schließt die Wanne 17 in Öffnungsrichtung Ö hin zum medizintechnischen Großgerät 3 ab Die Wanne 17 weist auf ihrer Unterseite eine Höhe H auf und an ihren Seitenwänden eine Breite B, die im Wesentlichen gleich dimensioniert sind, d. h. die Bodenwand und die Seitenwände sind gleich dick.

Durch die Verwendung des Vergussmaterials 15 kann sichergestellt werden, dass die Lastplatte 1 einen in sich stabilen Block darstellt, der als eine Masse und damit als Gegengewicht zum Großgerät 3 wirkt Die elastischen Federelemente 19 dienen mit ihren Teilelementen 19a, 19b dazu, in einer punktelastischen Lagerung bestimmte höhere mechanische Vibrationsfrequenzen gegenüber der Lastplatte 1 bereits abzufedern, während sich niedrigere Körperschallfrequenzen auf die Lastplatte 1 übertragen und von dieser durch ihre elastische Lagerung absorbiert werden. Eine zusätzliche Vibrationskompensation ist durch die unterseitig der Lastplatte 1 vollflächige Ausbildung der elastischen Federung 21 gewährleistet. Die Hochfrequenz-Abschirmungsschicht 23 schirmt die elektromagnetische Hochfrequenz-Strahlung so ab, dass weder die umliegende Umgebung durch das Großgerät 3, noch das Großgerät 3 durch Hochfrequenzstrahlung von außen nennenswert beeinflusst werden.

Die Lastplatte 1 ist in einer Kavität 35 des Bodens 25 eingelassen, so dass ihre Oberfläche leicht unterhalb der restlichen Oberfläche des Bodens 25 außerhalb des Bereichs der Kavität 35 liegt. Durch einen vertieften Verbau, der auch bündig mit der Oberfläche des Bodens 25 erfolgen kann, wird die Bauhöhe der Lagerungsanordnung 27 nochmals reduziert bzw. komplett kompensiert. Zum Abschluss der Lastplatte 1 an den Boden 25 sind zudem umlaufend um die Lastplatte 1 Gummi-Verbindungen 37 eingebaut, so dass ein fließender Übergang der Oberfläche des Bodens 25 und der Lastplatte 1 gewährleistet werden kann.

Figur 2 zeigt eine zweite Ausführungsform einer Lastplatte 1 Sie kann wie in Figur 1 im Rahmen einer Lagerungsanordnung verbaut werden, jedoch genau wie die Lastplatte 1 aus Figur 1 auch bereits alleine zur Lagerung eines medizintechnischen Großgeräts (hier nicht dargestellt) dienen.

Die Lastplatte 1' weist wiederum einen Hohlkörper 9' mit einer Wanne 17' und einem Deckel 18' auf. Der Unterschied zur Lastplatte 1 aus Figur 1 besteht im Wesentlichen darin, dass als Füllmaterial 13 nun ein Schüttgut in Form von Bleischrot oder Quarzsand verwendet wird. Dieses wird wiederum mit einem Vergussmaterial (aus Anschaulichkeitsgründen hier nicht angedeutet) verfüllt, so dass sich wiederum ein Verbund ergibt. Als Stabilisierungsträger 33 dienen hier eckige U-förmige Träger, die hier vorteilhafterweise in Richtung der Oberseite der Lastplatte geöffnet sind, so dass sie ebenfalls mit Füllmaterial 13 und Vergussmaterial befüllt sind.

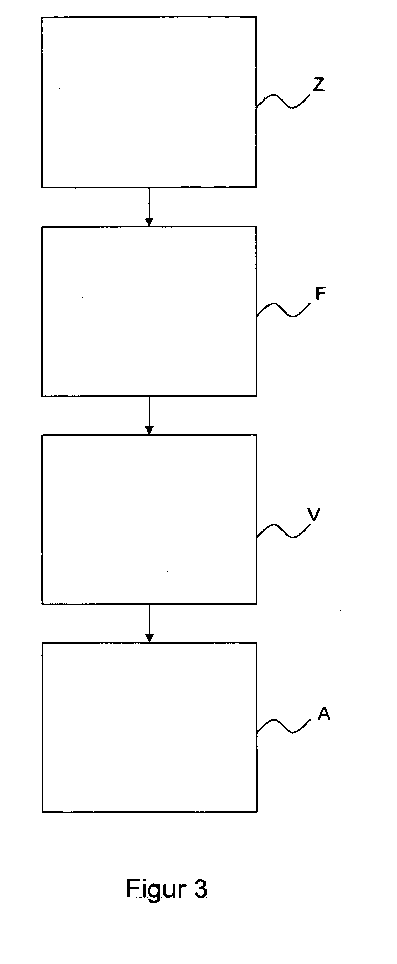

Figur 3 zeigt schematisch den Ablauf einer Ausführungsform eines erfindungsgemäßen Herstellungsverfahrens und - in Weiterbildung eines erfindungsgemäßen Verfahrens zur Lagerung eines medizintechnischen Großgeräts.

In einem Schritt Z wird ein flacher Hohlkörper 9, 9'aus nichtmagnetischem Material, beispielsweise in Wannenform, bereitgestellt. Er kann als ganzstückiges Teil angeliefert oder aus mehreren Teilen zusammengefügt werden, beispielsweise durch Verschweißen vor Ort.

Vor dem Aufstellen des Hohlkörpers 9, 9' wird bevorzugt der Boden 25 des Aufstellraums vorbereitet. Hierzu kann eine Kavität 35 darin ausgebildet werden, beispielsweise durch Ausfräsen. Weiterhin wird vorzugsweise eine Hochfrequenz-Abschirmungsschicht 23 und darüber eine elastische Federung 21 auf dem Boden aufgebracht. Auf diesem oder einem ähnlichen Aufbau wird nun der Hohlkörper 9, 9' angeordnet.

Er wird in einem Schritt F mit einem nichtmagnetischen Füllmaterial 11, 13 befüllt. Das Füllmaterial 11, 13 wird dann in einem Schritt V mit Hilfe eines sich verfestigenden Vergussmaterials 15 zu einem starren Verbund vergossen. Dieser Gesamtaufbau kann beispielsweise durch Aufbringen eines Deckels 18 verschlossen werden. Durch den Schritt F entsteht die Lastplatte 1, 1', so dass das Herstellungsverfahren diese ersten drei Schritte umfasst. Zusätzlich können weitere elastische Federelemente 19 auf die Oberseite der Lastplatte 1, 1' aufgebracht werden. Das Verfahren zur Lagerung umfasst sodann noch das Aufstellen A des medizintechnischen Großgeräts 3 auf der Lastplatte 1, 1'.

Es wird abschließend noch einmal darauf hingewiesen, dass es sich bei den vorhergehend beschriebenen Vorrichtungen lediglich um ein Ausführungsbeispiele handelt, die vom Fachmann in verschiedenster Weise modifiziert werden kann, ohne den Bereich der Erfindung zu verlassen. Insbesondere kann die Lastplatte einfacher ausgeführt sein und beispielsweise nur mit einem Füll- und einem Vergussmaterial gefüllt sein. Die Lagerungsanordnung kann andererseits auch mehr oder weniger Federungen umfassen. Weiterhin schließt die Verwendung der unbestimmten Artikel "ein" bzw. "eine" nicht aus, dass die betreffenden Merkmale auch mehrfach vorhanden sein können.

### Bezugszeichenliste:

- 1, 1': Lastplatte
- 3: medizintechnisches Großgerät
- 5: Magnet
- 7: Standbeine
- 9, 9': Hohlkörper
- 11: Füllmaterial - Materialplatten
- 13: Füllmaterial - Schüttgut
- 15: Vergussmaterial
- 17, 17': Wanne
- 18, 18': Deckel
- 19: elastische Federelemente
- 19a, 19b: Teilelemente
- 21: elastische Federung
- 23: Hochfrequenz-Abschirmungsschicht
- 25: Boden
- 27: Lagerungsanordnung
- 29: medizintechnische Anordnung
- 31: Stabilisierungsträger - Vierkantrohr
- 33: Stabilisierungsträger - U-förmiger Träger
- 35: Kavität
- 37: Gummi-Verbindung
- A: Verfahrensschritt - Aufstellen
- B: Breite
- F: Verfahrensschritt - Befüllen
- H: Höhe
- Ö: Öffnungsrichtung
- V: Verfahrensschritt - Vergießen
- Z: Verfahrensschritt - Bereitstellung

## Patentansprüche

1. Lastplatte (1, 1') zur Lagerung eines medizintechnischen Großgeräts, insbesondere eines Magnetresonanzaufnahmegeräts (3), mit einem flachen Hohlkörper (9, 9'), der mit einem Füllmaterial (11, 13) hoher Dichte gefüllt ist, wobei das Füllmaterial (11, 13) in sich mit Hilfe eines verfestigten Vergussmaterials (15) zu einem starren Verbund vergossen ist und sowohl der Hohlkörper (9, 9') als auch das Füllmaterial (11, 13) und das Vergussmaterial (15) aus nichtmagnetischem Material bestehen.

2. Lastplatte gemäß Anspruch 1, **dadurch gekennzeichnet, dass** der Hohlkörper (9, 9') eine Wanne (17, 17') umfasst.

3. Lastplatte gemäß Anspruch 2, **dadurch gekennzeichnet, dass** sie einen die Wanne (17, 17') in Öffnungsrichtung (Ö) mindestens teilweise abdeckenden Deckel (18, 18') umfasst.

4. Lastplatte gemäß einem der vorhergehenden Ansprüche, **dadurch gekennzeichnet, dass** im oder am Hohlkörper (9, 9') ein Stabilisierungsträger (31, 33) aus nichtmagnetischem Material angeordnet ist.

5. Lastplatte gemäß einem der vorgehenden Ansprüche, **dadurch gekennzeichnet, dass** der Hohlkörper (9, 9') und/oder der Stabilisierungsträger (31, 33) zumindest überwiegend aus Edelstahl besteht.

6. Lastplatte gemäß einem der vorhergehenden Ansprüche, **dadurch gekennzeichnet, dass** das Füllmaterial ein Schüttgut (13) umfasst.

7. Lastplatte gemäß einem der vorhergehenden Ansprüche, **dadurch gekennzeichnet, dass** das Vergussmaterial (15) ein Gießharz umfasst.

8. Lastplatte gemäß einem der vorhergehenden Ansprüche, **dadurch gekennzeichnet, dass** das Vergussmaterial (15) ein Material umfasst, das vor dem Verfestigen bei Raumtemperatur einen flüssigen oder zähflüssigen Zustand aufweist.

9. Lagerungsanordnung (27) mit einer auf einer Oberfläche eines Bodens (25) eines Aufstellraums angeordneten Lastplatte (1, 1') gemäß einem der vorhergehenden Ansprüche.

10. Lagerungsanordnung gemäß Anspruch 9, **dadurch gekennzeichnet, dass** die Lastplatte (1, 1') in die Oberfläche des Bodens (25) eingelassen ist.

11. Lagerungsanordnung gemäß Anspruch 10, **dadurch gekennzeichnet, dass** die Lastplatte (1, 1') mit ihrer dem medizintechnischen Großgerät (3) zugewandten Oberseite im Wesentlichen in einer Ebene mit einer Oberfläche des Bodens (25) oder darunter angeordnet ist.

12. Verwendung einer Lastplatte (1, 1') gemäß einem der Ansprüche 1 bis 8, insbesondere einer Lagerungsanordnung (27) gemäß einem der Ansprüche 9 bis 11, zur Lagerung eines medizintechnischen Großgeräts (3), insbesondere eines Magnetresonanzaufnahmegeräts.

13. Medizintechnische Anordnung (29), umfassend ein medizintechnisches Großgerät (3), insbesondere ein Magnetresonanzaufnahmegerät, und eine Lastplatte (1, 1') gemäß einem der Ansprüche 1 bis 8, insbesondere eine Lagerungsanordnung (27) gemäß einem der Ansprüche 9 bis 11.

14. Herstellungsverfahren für eine Lastplatte (1, 1') zur Lagerung eines medizintechnischen Großgeräts (3), insbesondere eines Magnetresonanzaufnahmegeräts, aufweisend folgende Schritte:
a) Bereitstellen (B) eines flachen Hohlkörpers (9, 9') aus nichtmagnetischem Material,
b) Füllen (F) des Hohlkörpers (9, 9') mit einem nichtmagnetischen Füllmaterial (11, 13) hoher Dichte,
c) Vergießen (V) des Füllmaterials (11, 13) in sich mit Hilfe eines sich verfestigenden Vergussmaterials (15) zu einem starren Verbund.

15. Verfahren zur Lagerung eines medizintechnischen Großgeräts (3), insbesondere eines Magnetresonanzaufnahmegeräts an einem Einsatzort des Großgeräts (3), aufweisend folgende Schritte:
a) Bereitstellen (B) eines flachen Hohlkörpers (9, 9') aus nichtmagnetischem Material,
b) Füllen (F) des Hohlkörpers (9, 9') mit einem nichtmagnetischen Füllmaterial (11, 13) hoher Dichte vor Ort,
c) Vergießen (V) des Füllmaterials (11, 13) in sich vor Ort mit Hilfe eines sich verfestigenden Vergussmaterials (15) zu einem starren Verbund, sodass aus dem Hohlkörper (9, 9') mit dem starren Verbund eine Lastplatte (1, 1') entsteht,
d) Aufstellen (A) des medizinischen Großgeräts (3) auf der Lastplatte (1, 1').

## Claims

1. A bearing plate (1, 1') for supporting a large-sized medical technical apparatus, particularly a magnetic resonance imaging device (3), with a flat hollow body (9, 9') that is filled with a filler (11, 13) of high density, wherein the filler (11, 13) is in itself cast into a rigid composite structure with the aid of a cured casting material (15) and the hollow body (9, 9'), as well as the filler (11, 13) and the casting material (15), consist of non-magnetic material.

2. Bearing plate according to claim 1, **characterized in that** the hollow body (9, 9') comprises a trough (17, 17').

3. Bearing plate according to claim 2, **characterized in that** it comprises a covering lid (18, 18') that at least partially covers the trough (17, 17') in the direction of the opening (Ö).

4. Bearing plate according to one of the preceding claims, **characterized in that** a stabilizing beam (31, 33) of non-magnetic material is arranged in or on the hollow body (9, 9').

5. Bearing plate according to one of the preceding claims, **characterized in that** the hollow body (9, 9') and/or the stabilizing beam (31, 33) at least predominantly consist of special steel.

6. Bearing plate according to one of the preceding claims, **characterized in that** the filler comprises a bulk material (13).

7. The bearing plate according to one of the preceding claims, **characterized in that** the casting material (15) comprises a casting resin.

8. Bearing plate according to one of the preceding claims, **characterized in that** the casting material (15) comprises a material that is in a liquid or semi-liquid state prior to curing at room temperature.

9. A support arrangement (27) with a bearing plate (1, 1') according to one of the preceding claims that is arranged on a surface of a floor (25) of the installation site.

10. Support arrangement according to claim 9, **characterized in that** the bearing plate (1, 1') is recessed into the surface of the floor (25).

11. Support arrangement according to claim 10, **characterized in that** the upper side of the bearing plate (1, 1') that faces the large-sized medical technical apparatus (3) is essentially arranged at or below the level of the surface of the floor (25).

12. Utilization of a bearing plate (1, 1') according to one of claims 1 to 8, particularly a support arrangement (27) according to one of claims 9 to 11, for supporting a large-sized medical technical apparatus (3), particularly a magnetic resonance imaging device.

13. A medical technical arrangement (29) comprising a large-sized medical technical apparatus (3), particularly a magnetic resonance imaging device, and a bearing plate (1, 1') according to one of claims 1 to 8, particularly a support arrangement (27) according to one of claims 9 to 11.

14. A method for manufacturing a bearing plate (1, 1') for supporting a large-sized medical technical apparatus (3), particularly a magnetic resonance imaging device, featuring the following steps:
a) making available (B) a flat hollow body (9, 9') of non-magnetic material,
b) filling (F) the hollow body (9, 9') with a non-magnetic filler (11, 13) of high density,
c) casting (V) the filler (11, 13) in itself into a rigid composite structure with the aid of a curing casting material (15).

15. A method for supporting a large-sized medical technical apparatus (3), particularly a magnetic resonance imaging device, at an installation site of the large-sized device (3), featuring the following steps:
a) making available (B) a flat hollow body (9, 9') of non-magnetic material,
b) filling (F) the hollow body (9, 9') with a non-magnetic filler (11, 13) of high density,
c) casting (V) the filler (11, 13) in itself into a rigid composite structure on-site with the aid of a curing casting material (15) such that a bearing plate (1, 1') is formed of the hollow body (9, 1') with the rigid composite structure,
d) installing (A) the large-sized medical device (3) on the bearing plate (1, 1').

## Revendications

1. Plaque porte-charge (1, 1`) pour l'entreposage d'un appareil médico-technique de grande taille, en particulier d'un appareil d'enregistrement par résonance magnétique (3), avec un corps creux plat (9, 9'), lequel est rempli avec un matériau de remplissage (11, 13) de haute densité, le matériau de remplissage (11, 13) en soi étant scellé à l'aide d'un matériau de scellement (15) durci pour donner un composite rigide, et le corps creux (9, 9') tout comme également le matériau de remplissage (11, 13) et le matériau scellement (15) étant composés d'un matériau non magnétique.

2. Plaque porte-charge selon la revendication 1, **caractérisé en ce que** le corps creux (9, 9') comprend une cuvette (17, 17').

3. Plaque porte-charge selon la revendication 2, **caractérisée en ce qu'**elle comprend un couvercle (18, 18') recouvrant au moins partiellement la cuvette (17, 17') en direction d'ouverture (Ö).

4. Plaque porte-charge selon l'une des revendications précédentes, **caractérisée en ce qu'**un support de stabilisation (31, 33) en un matériau non magnétique est disposé dans le corps creux (9, 9') ou sur celui-ci.

5. Plaque porte-charge selon l'une des revendications précédentes, **caractérisée en ce que** le corps creux (9, 9') et/ou le support de stabilisation (31, 33) se compose(nt) au moins essentiellement d'acier inoxydable.

6. Plaque porte-charge selon l'une des revendications précédentes, **caractérisée en ce que** le matériau de remplissage comprend un produit en vrac (13).

7. Plaque porte-charge selon l'une des revendications précédentes, **caractérisée en ce que** le matériau de scellement (15) est une résine de coulée.

8. Plaque porte-charge selon l'une des revendications précédentes, **caractérisée en ce que** le matériau de scellement (15) comprend un matériau, lequel présente un état liquide ou visqueux avant le durcissement à température ambiante.

9. Agencement d'entreposage (27) avec une plaque porte-charge (1, 1') selon l'une des revendications précédentes disposée sur une surface d'un sol (25) d'un espace de montage.

10. Agencement d'entreposage selon la revendication 9, **caractérisé en ce que** la plaque porte-charge (1, 1') est encastrée dans la surface du sol (25).

11. Agencement d'entreposage selon la revendication 10, **caractérisé en ce que** la plaque porte-charge (1, 1') est disposée, avec sa face supérieure tournée vers l'appareil médico-technique de grande taille (3), sensiblement dans un plan avec une surface du sol (25) ou bien en-dessous.

12. Utilisation d'une plaque porte-charge (1, 1') selon l'une des revendications 1 à 8, en particulier d'un agencement d'entreposage (27) selon l'une des revendications 9 à 11, pour l'entreposage d'un appareil médico-technique de grande taille (3), en particulier d'un appareil d'enregistrement par résonance magnétique.

13. Agencement médico-technique (29) comprenant un appareil médico-technique de grande taille (3), en particulier un appareil d'enregistrement par résonance magnétique, et une plaque porte-charge (1, 1') selon l'une des revendications 1 à 8, en particulier un agencement d'entreposage (27) selon l'une des revendications 9 à 11.

14. Procédé de fabrication pour une plaque porte-charge (1, 1') pour l'entreposage d'un appareil médico-technique de grande taille (3), en particulier d'un appareil d'enregistrement par résonance magnétique, présentant les étapes suivantes :
a) mise à disposition (B) d'un corps creux plat (9, 9') en un matériau non magnétique,
b) remplissage (F) du corps creux (9, 9') avec un matériau de remplissage (11, 13) non magnétique de haute densité,
c) scellement (V) du matériau de remplissage (11, 13) en soi à l'aide d'un matériau de scellement (15) se durcissant pour donner un composite rigide.

15. Procédé pour l'entreposage d'un appareil médico-technique de grande taille (3), en particulier d'un appareil d'enregistrement par résonance magnétique, sur un lieu d'utilisation de l'appareil de grande taille (3), présentant les étapes suivantes :
a) mise à disposition (B) d'un corps creux plat (9, 9') en un matériau non magnétique,
b) remplissage (F) sur place du corps creux (9, 9') avec un matériau de remplissage (11, 13) non magnétique de haute densité,
c) scellement (V) du matériau de remplissage (11, 13) en soi, sur place, à l'aide d'un matériau de scellement (15) se durcissant pour donner un composite rigide de manière à ce que le corps creux (9, 9') avec le composite rigide donnent une plaque porte-charge (1, 1'),
d) mise en place (A) de l'appareil médical de grande taille (3) sur la plaque porte-charge (1, 1').
